# EUROPEAN PATENT APPLICATION

(11) **EP 4 796 233 A1**
(43) Date of publication of application: **26.08.2026**
(21) Application number: 24879635.1
(22) Date of filing: 09.10.2024
(51) Int. Cl.: B06B 1/04, G06F 3/01, G06F 3/041, H02K 33/16

(54) **VIBRATION ACTUATOR AND CONTACT-TYPE INPUT DEVICE**

(30) Priority: 16.10.2023 JP 2023178484
(71) Applicant: Minebea Mitsumi Inc., Kitasaku-gun, Nagano 3890293 (JP)
(72) Inventor: KINOSHITA, Yosuke, Tokyo 206-8567 (JP); SATO, Soichi, Tokyo 206-8567 (JP)
(74) Representative: Epping - Hermann - Fischer
(86) International application number: PCT/JP2024/036114
(87) International publication number: WO 2025/084210

(57) **Abstract**

This vibration actuator comprises: a magnet; a core having a coil; a plate-shaped upper frame body; a plate-shaped lower frame body; and a plate-shaped elastic part which extends into a frame from an end part disposed at a position overlapping the upper frame body and the lower frame body in a plan view, and which holds either the magnet or the core so as to be able to vibrate in the frame. The end part is sandwiched between the upper frame body and the lower frame body such that the magnet and the core face each other in the frame.

## Description

### Technical Field

The present invention relates to a vibration actuator and a contact-type input device including the vibration actuator.

### Background Art

Conventionally, a configuration is known in which vibration is imparted, by a vibration actuator, as a haptic operational sensation (a sensation of operating by touch) to a finger pad or the like of an operator who touches a display screen displayed on a touch panel (see Patent Literature (hereinafter, referred to as "PTL") 1).

PTL 1 discloses a mobile terminal device in which a vibration actuator is attached to a back side of a touch panel via a vibration transmitting part. In the vibration actuator of this device, a movable element is disposed within a housing fixed to the vibration transmitting part so as to be capable of reciprocating movement along a guide shaft disposed perpendicular to the touch panel. In the vibration actuator, vibration is imparted to a finger pad in contact with the touch panel via the vibration transmitting part by causing the movable element to collide with the housing in response to an operation on the touch panel.

### Citation List

### Patent Literature

PTL 1
Japanese Patent Application Laid-Open No. 2015-070729

### Summary of Invention

### Technical Problem

Incidentally, in the vibration actuator of PTL 1, since the movable element reciprocates along the guide shaft disposed perpendicular to the display surface of the touch panel, the device itself has a length in a direction perpendicular to the display surface, that is, the device has a thickness.

There is a demand for a vibration actuator capable of achieving a reduced thickness and a lower profile for the device; however, simply reducing the thickness gives rise to a problem of decreased rigidity of the device itself.

An object of the present invention is to provide a vibration actuator and a contact-type input device each capable of ensuring rigidity even when the thickness is reduced.

### Solution to Problem

A vibration actuator according to the present invention includes: a magnet; a core that includes a coil; an upper frame body having a plate shape; a lower frame body having a plate shape; and an elastic portion that includes an end portion disposed at a position overlapping with the upper frame body and the lower frame body in plan view, extends from the end portion into an inside of a frame, and vibratably holds either the magnet or the core inside the frame, in which the end portion is interposed between the upper frame body and the lower frame body such that the magnet and the core face each other in the frame.

A contact-type input device according to the present invention is a contact-type input device in which the above- described vibration actuator is disposed on a back side of an operation surface, and includes a control section that energizes the coil in response to a touch operation of a user on the operation surface and vibrates the magnet or the core to present a haptic sensation to the user.

### Advantageous Effects of Invention

According to the present invention, rigidity can be ensured even when the thickness is reduced.

### Brief Description of Drawings

[FIG. 1] FIG. 1 is an external perspective view of a vibration actuator according to an embodiment of the present invention;
[FIG. 2] FIG. 2 is a side view of the vibration actuator illustrated in FIG. 1;
[FIG. 3] FIG. 3 is an exploded perspective view of the vibration actuator illustrated in FIG. 1;
[FIG. 4] FIG. 4 is a cross-sectional view taken along line A-A of the vibration actuator illustrated in FIG. 1;
[FIG. 5] FIG. 5 is a plan view showing a state in which a cover frame, a movable portion, and a core portion are removed from the vibration actuator illustrated in FIG. 1;
[FIG. 6] FIG. 6 is an exploded perspective view of the core portion in the vibration actuator illustrated in FIG. 1;
[FIG. 7] FIG. 7 is a diagram for describing the movable portion and the core portion in the vibration actuator illustrated in FIG. 1;
[FIG. 8] FIG. 8 is a diagram illustrating an example of a vibration presentation device including the vibration actuator illustrated in FIG. 1;
[FIG. 9] FIG. 9 is an external perspective view of a vibration actuator as a variation (Variation 1) of the vibration actuator illustrated in FIG. 1;
[FIG. 10] FIG. 10 is an external perspective view of a vibration actuator as a variation (Variation 2) of the vibration actuator illustrated in FIG. 1;
[FIG. 11] FIG. 11 is an external perspective view of a vibration actuator as a variation (Variation 3) of the vibration actuator illustrated in FIG. 1;
[FIG. 12] FIG. 12 is an exploded perspective view of the vibration actuator illustrated in FIG. 11; and
[FIG. 13] FIG. 13 is a cross-sectional view taken along line E-E of the vibration actuator illustrated in FIG. 11.

### Description of Embodiments

Hereinafter, an embodiment according to the present invention will be described in detail with reference to the drawings.

In the present embodiment, the description will be made using an orthogonal coordinate system (X, Y, Z). The same orthogonal coordinate system (X, Y, Z) is also used for illustration of below-mentioned figures. In the following, the width direction, the depth direction, and the height direction (thickness direction) of vibration actuators 10A to 10C and vibration presentation device 100 are referred to as the X direction, the Y direction, and the Z direction, respectively.

In addition, in the present embodiment, in vibration actuators 10A to 10C and vibration presentation device 100, the positive Z-direction side is described as the upper side (or front side), and the negative Z-direction side is described as the lower side (or back side).

### [Configuration of Vibration Actuator]

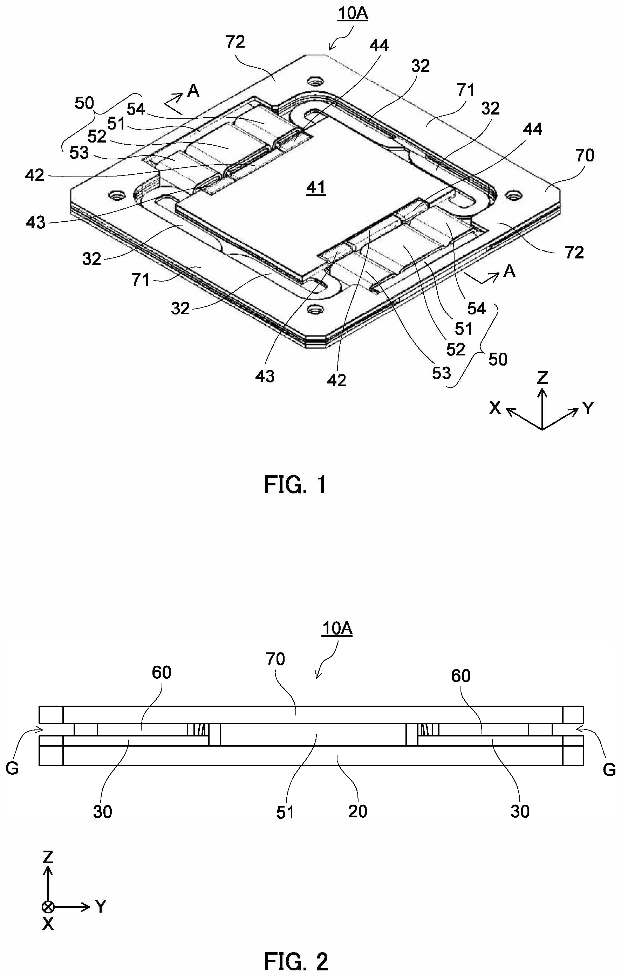

Vibration actuator 10A according to the present embodiment will be described with reference to FIGS. 1 to 6.

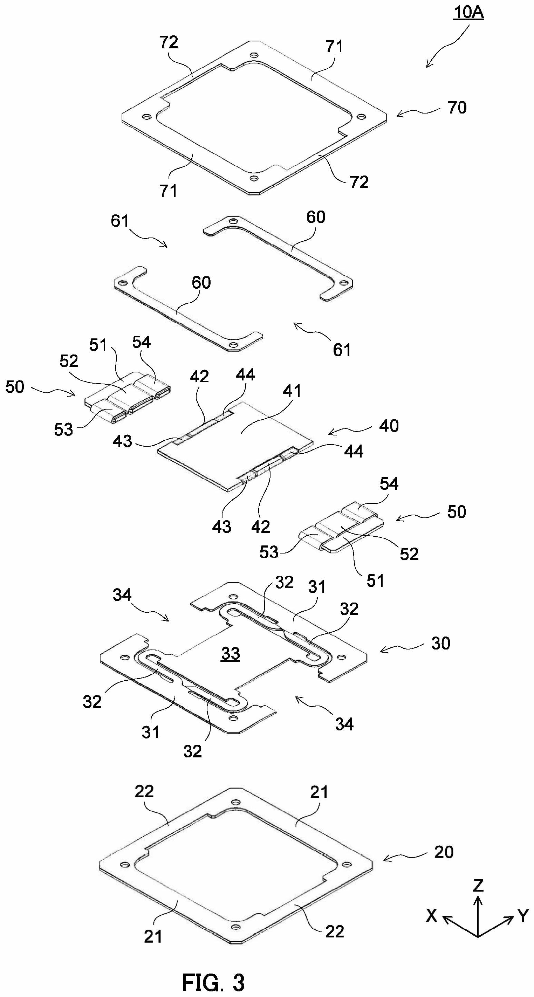

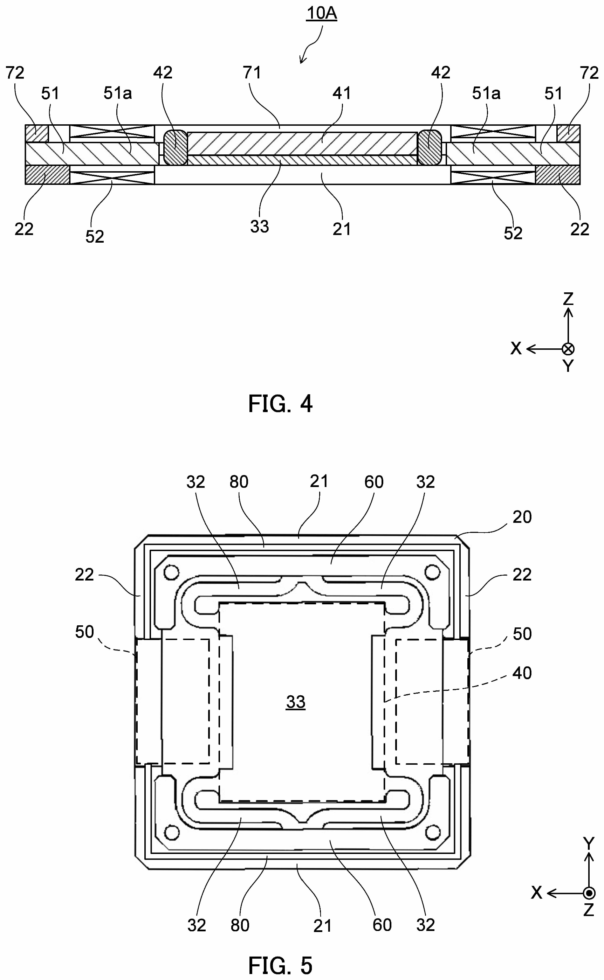

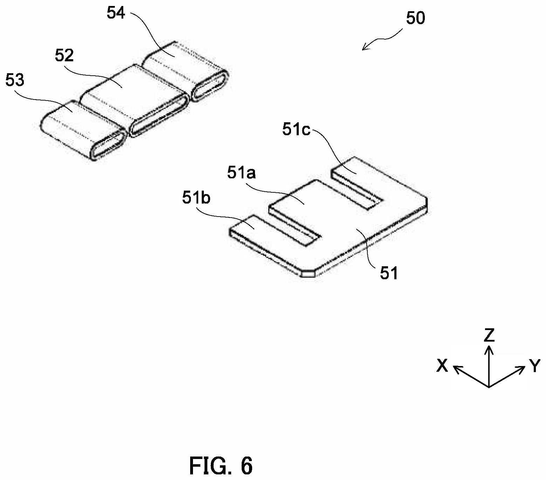

FIG. 1 is an external perspective view of vibration actuator 10A according to the embodiment of the present invention. FIG. 2 is a side view of vibration actuator 10A. FIG. 3 is an exploded perspective view of vibration actuator 10A. FIG. 4 is a cross-sectional view of vibration actuator 10A taken along line A-A. FIG. 5 is a plan view showing a state in which cover frame 70, movable portion 40, and core portion 50 are removed from vibration actuator 10A. FIG. 6 is an exploded perspective view of core portion 50 in vibration actuator 10A. Note that, in FIGS. 2 and 4, vibration actuator 10A is illustrated in an enlarged manner in the thickness direction for the sake of description.

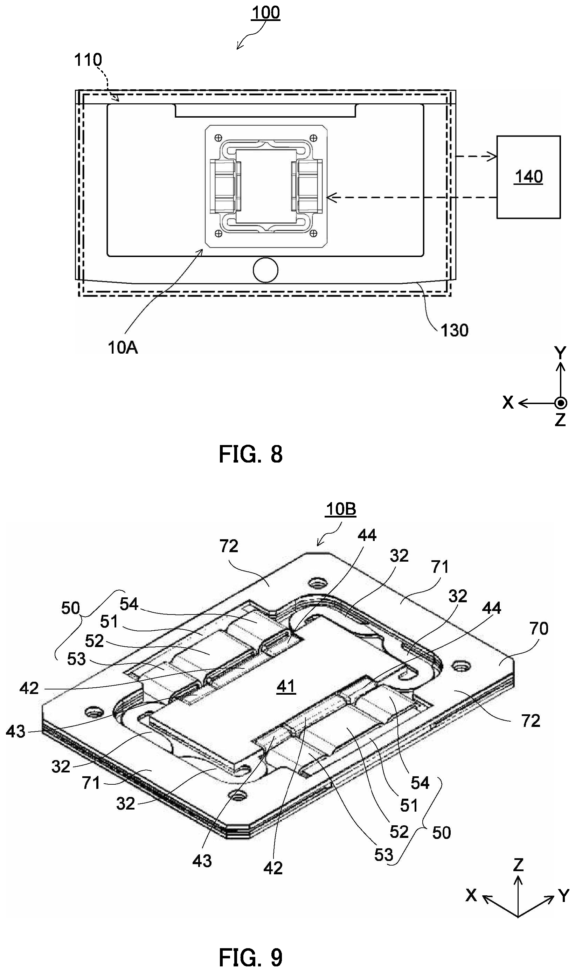

Vibration actuator 10A is used, for example, as a vibration presentation device in a contact-type input device (e.g., trackpad or the like) which is an operation device operated by a touch operation of an operator, as illustrated in FIG. 8 described later, and presents vibration to the operator via an operation surface (vibration presentation portion).

Vibration actuator 10A can vibrate the operation surface of the operation device as described above, thereby imparting a haptic operational sensation (also referred to as "haptic sensation" or "force sensation") to the operator who operates the operation surface by touching the operation surface, depending on the application or the usage situation of the operation device.

Vibration actuator 10A is a thin vibration actuator configured in a flat plate shape or a thin plate shape (low-profile) as a whole. That is, vibration actuator 10A is configured such that the occupied space in the thickness direction, which is the vibration direction, is as small as possible within a range in which movable portion 40 described later can be movable.

In the present embodiment, vibration actuator 10A includes base frame 20, elastic portion 30, movable portion 40, core portion 50, spacer 60, and cover frame 70 (see FIG. 3 in particular).

Base frame 20, elastic portion 30, movable portion 40, core portion 50, spacer 60, and cover frame 70 are each formed in a flat or thin plate shape, and are stacked to configure thin vibration actuator 10A.

Base frame 20 (lower frame body in the present invention) is a frame body having a flat or thin plate-shape, and the inside of the frame is open. Base frame 20 is, for example, a frame body having a rectangular shape in plan view, and includes first side portions 21 facing each other in the Y direction and second side portions 22 facing each other in the X direction, which is different from the direction of first side portion 21. Base frame 20 interposes elastic portion 30 and the like between itself and cover frame 70 and vibratably holds movable portion 40 via elastic portion 30.

Elastic portion 30 is an elastic member having a flat or thin plate shape, and includes end portions 31, arms 32, and holding portion 33.

End portions 31 are both ends of elastic portion 30 in the Y direction, and are disposed at positions overlapping with base frame 20 and cover frame 70 in plan view. Specifically, end portions 31 are disposed at positions overlapping with first side portions 21 of base frame 20 and first side portions 71 of cover frame 70, which will be described later. With such disposition, end portions 31 are interposed between base frame 20 (first side portions 21) and cover frame 70 (first side portions 71).

Arms 32 are four arms that extend from end portions 31 at both ends to holding portion 33 disposed between end portions 31 at both ends, and are portions that elastically deform when movable portion 40 held by holding portion 33 vibrates.

As an example, arms 32 each have a shape that extends from the center of end portion 31 in the X direction toward the outside in the X direction and then meanders toward the inside in the X direction to be connected to holding portion 33. In this manner, by forming arms 32 into meandering shapes, the lengths of elastically deformable arms 32 can be set to desired lengths and the vibration of movable portion 40 can be set to a desired resonance frequency, even when the overall size and length of elastic portion 30 are limited.

On the positive side in the Y direction, two arms 32 connect one end portion 31 and holding portion 33, and on the negative side in the Y direction, two arms 32 connect the other end portion 31 and holding portion 33.

Holding portion 33 is disposed between end portions 31 at both ends via four arms 32. Weight portion 41 of movable portion 40 is fixed to holding portion 33 via a fixing material such as an adhesive, a fastening member, or a pressure-sensitive adhesive material, so that holding portion 33 holds movable portion 40.

In elastic portion 30, regions 34 in which no member constituting elastic portion 30 is disposed are formed in portions of areas overlapping with second side portions 22 of base frame 20 and second side portions 72 of cover frame 70 described later. Cores 51 of core portion 50 described later are disposed in regions 34, and cores 51 are interposed between base frame 20 (second side portions 22) and cover frame 70 (second side portions 72).

Movable portion 40 includes weight portion 41 and a set of magnets 42 to 44. Weight portion 41 is a flat or thin plate-shaped member, and functions as a weight that promotes vibration. As described above, weight portion 41 is fixed to holding portion 33 via a fixing material such as an adhesive, a fastening member, or a pressure-sensitive adhesive material.

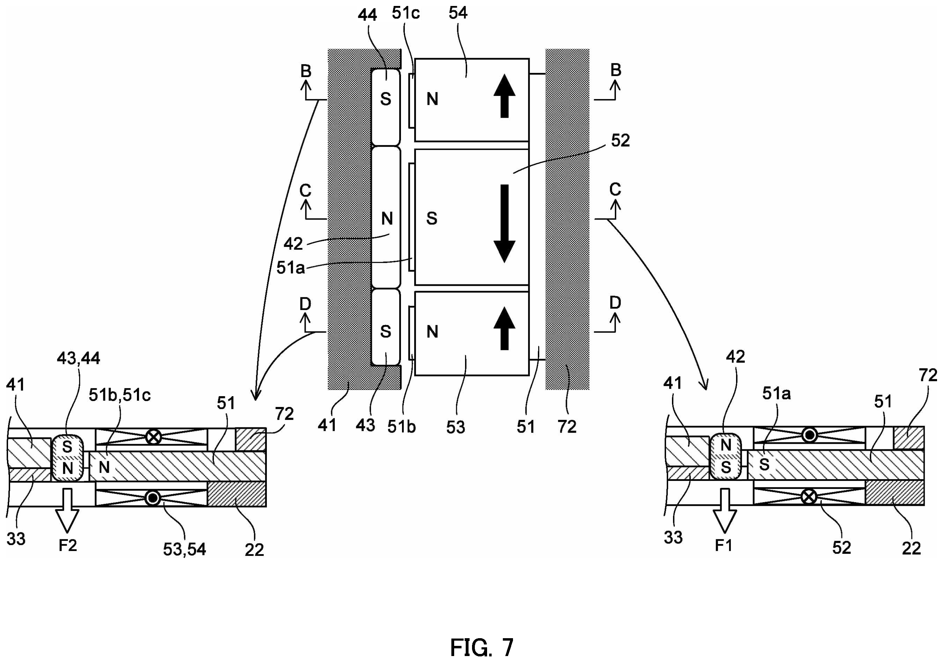

Weight portion 41 holds a set of magnets 42 to 44 at both ends in the X direction. Here, as an example, recessed portions are provided at both ends of weight portion 41 in the X direction, and three magnets 42 to 44 are fixed to each of the recessed portions. Magnets 42 to 44 will be described later with reference to FIG. 7.

In addition, since movable portion 40 is disposed inside of the frames of base frame 20 and cover frame 70, no other member is disposed above and below (in the vibration direction) movable portion 40. Therefore, the thickness of movable portion 40 can be maximally ensured within the thickness range of vibration actuator 10A. In this case, the movable range of movable portion 40 (the thickness of movable portion 40 plus the displacement amount in the vibration direction) is set to fall within the thickness range of vibration actuator 10A. This makes it possible to increase the magnetic force of magnets 42 to 44 and also to increase the weight of weight portion 41.

Core portion 50 is provided corresponding to each of the magnet portions (magnets 42 to 44) at both ends of movable portion 40. Each core portion 50 includes core 51 and coils 52 to 54. Coils 52 to 54 and core magnetic poles 51a to 51c described below are disposed to face magnets 42 to 44 with a gap therebetween.

As illustrated in FIG. 6, core 51 is a member formed of a flat or thin plate-shaped magnetic body having an E-shape in plan view, and includes three core magnetic poles 51a to 51c. As an example, in core 51, the width (length) of core magnetic pole 51a at the center is greater than that of core magnetic poles 51b and 51c at both ends in the Y direction, and the widths of core magnetic poles 51b and 51c at both ends are the same.

Coils 52 to 54 are wound around respective core magnetic poles 51a to 51c. In this manner, by providing a plurality of core magnetic poles 51a to 51c in core 51, the number of turns of coils 52 to 54 can be increased, and the magnetic force can be strengthened. Furthermore, as described with reference to FIG. 7, since both the S and N poles of core portion 50 are utilized, movable portion 40 including magnets 42 to 44 can be vibrated with a stronger magnetic force.

Furthermore, since coils 52 to 54 are disposed inside the frames of base frame 20 and cover frame 70, no other member is disposed above or below coils 52 to 54. Therefore, the thickness of coils 52 to 54 can be maximally ensured within the thickness range of vibration actuator 10A. This allows movable portion 40 including magnets 42 to 44 to be vibrated with a stronger magnetic force.

Spacer 60 is a pair of members each having a flat or thin plate shape, and is interposed between elastic portion 30 (end portions 31) and cover frame 70 (first side portions 71).

In the pair of spacers 60, regions 61 in which no member constituting spacer 60 is disposed are formed in portions of areas overlapping with second side portions 22 of base frame 20 and second side portions 72 of cover frame 70. Core 51 of core portion 50 is disposed in each of regions 61, and core 51 is interposed between base frame 20 (second side portion 22) and cover frame 70 (second side portion 72). Furthermore, the thickness of core 51 can be ensured even in thin vibration actuator 10A by means of regions 34 in elastic portion 30 described above and regions 61 formed by the pair of spacers 60.

In the present embodiment, spacer 60 is provided to form gap G between elastic portion 30 (end portion 31) and cover frame 70 (second side portion 72), as illustrated in FIG. 2. Therefore, in the Y direction, the width (length) of spacer 60 is shorter than those of end portions 31 of elastic portion 30 and second side portions 72 of cover frame 70. As illustrated in FIG. 5, Flexible Printed Circuit (FPC) 80 serving as a wiring portion connected to coils 52 to 54 is disposed in gap G.

Spacer 60 is also provided to ensure (expand) the movable range of movable portion 40 in the Z direction.

Note that spacer 60 need not be provided in vibration actuator 10A when it is not necessary to dispose FPC 80 in gap G or to ensure the movable range of movable portion 40. In this case, the thickness of elastic portion 30 and the thickness of core 51 of core portion 50 are made equal so as to prevent a gap from being formed between cover frame 70 and elastic portion 30 and causing a decrease in rigidity.

Cover frame 70 (upper frame body in the present invention) is a frame body formed in a flat or thin plate shape, the inside of the frame is open. As an example, cover frame 70 is a rectangular frame body in plan view, and is constituted by first side portions 71 facing each other in the Y direction and second side portions 72 facing each other in the X direction, which is different from the direction of first side portions 71. Cover frame 70 interposes elastic portion 30 and cores 51 between itself and base frame 20.

Vibration actuator 10A is configured by stacking base frame 20, elastic portion 30, movable portion 40, core portion 50, spacer 60, and cover frame 70, each of which is a flat or thin plate-shaped member. In vibration actuator 10A, the stacked members are fixed to each other using screws or the like as fastening members. Note that an adhesive, welding, or the like may be used as the fastening members.

In vibration actuator 10A, arms 32 and holding portion 33 of elastic portion 30, movable portion 40, and core magnetic poles 51a to 51c and coils 52 to 54 of core portion 50 are disposed inside the frames of base frame 20 and cover frame 70. Furthermore, magnets 42 to 44 of movable portion 40 and core magnetic poles 51a to 51c and coils 52 to 54 of core portion 50 are disposed so as to face each other in the X direction with a gap therebetween.

Counting from the back side toward the front side, the first layer is base frame 20, the second layer is elastic portion 30 and core portion 50, the third layer is movable portion 40, core portion 50, and spacer 60, and the fourth layer is cover frame 70.

In this manner, the second and third layers each include a plurality of members. In vibration actuator 10A, end portions 31 of elastic portion 30 and cores 51 of core portion 50 in the second layer, and cores 51 of core portion 50 and spacer 60 in the third layer, are interposed between base frame 20 and cover frame 70, which serve as frame bodies. This ensures rigidity even when vibration actuator 10A is reduced in thickness.

### [Operation of Vibration Actuator]

FIG. 7 is a diagram for describing movable portion 40 and core portion 50 in vibration actuator 10A.

In the present embodiment, magnets 42 to 44 of movable portion 40 are magnetized in the vibration direction (Z direction), as illustrated in FIG. 7. For example, magnet 42 at the center is magnetized in the S-to-N direction from the back side toward the front side. On the other hand, magnets 43 and 44 at both ends are magnetized in the N-to-S direction from the back side toward the front side. That is, magnets 42 to 44 are arranged such that adjacent magnets have opposite magnetic poles (magnetization directions).

In coils 52 to 54 of core portion 50 facing the respective magnets 42 to 44, windings are wound such that the winding direction of coil 52 is opposite to that of coils 53 and 54. That is, coils 52 to 54 are configured such that adjacent coils have opposite winding directions.

As one example, the S-pole side of magnet 42 is disposed so as to face central core magnetic pole 51a of core 51, and the N-pole sides of magnets 43 and 44 are disposed so as to face the core magnetic poles 51b and 51c at both ends of core 51, respectively.

In the configuration of movable portion 40 and core portion 50 described above, when a voltage is applied to coils 52 to 54 and current flows in the direction indicated by the bold arrows, the end of central core magnetic pole 51a of core 51 is magnetized to the S pole, and the ends of core magnetic poles 51b and 51c at both ends of core 51 are magnetized to the N pole. As a result, the N pole of magnet 42 at the center is attracted to central core magnetic pole 51a magnetized to the S pole, and attractive force F1 acting in the downward direction is exerted on magnet 42. Furthermore, the S poles of magnets 43 and 44 at both ends are attracted to core magnetic poles 51b and 51c at both ends magnetized to the N pole, respectively, and attractive force F2 acting in the downward direction is exerted on each of magnets 43 and 44. Movable portion 40, which is supported by elastic portion 30 so as to be capable of elastic vibration, is displaced downward by attractive forces F1 and F2.

Thereafter, when the application of voltage to coils 52 to 54 is stopped, movable portion 40 displaced downward moves upward due to the elastic force of arms 32 of elastic portion 30, whereby elastic vibration of movable portion 40 begins. Subsequently, by controlling the voltage supplied to coils 52 to 54, for example, by controlling voltage pulses such as square waves or sine waves, movable portion 40 can be vibrated in various vibration patterns.

### [Summary]

As described above, in vibration actuator 10A, end portion 31 of elastic portion 30, core 51 of core portion 50, and the like are interposed between base frame 20 and cover frame 70, which serve as frame bodies. This ensures the overall rigidity of vibration actuator 10A even when vibration actuator 10A is reduced in thickness. The rigidity of vibration actuator 10A as a whole can be further improved by increasing the thickness of base frame 20 and cover frame 70 to the extent possible.

Furthermore, movable portion 40 and coils 52 to 54 of core portion 50 are disposed inside the frames of base frame 20 and cover frame 70. Since no other member is disposed in the vibration direction of movable portion 40 or in the thickness direction of coils 52 to 54, the thickness of movable portion 40 and coils 52 to 54 can be maximally ensured within the thickness range of vibration actuator 10A even when vibration actuator 10A is reduced in thickness. This makes it possible to improve attractive forces F1 and F2 described above.

Furthermore, when assembling (stacking) vibration actuator 10A, assembly accuracy can be improved by using base frame 20 at the lowermost position or cover frame 70 at the uppermost position as a reference.

Furthermore, since vibration actuator 10A has a structure in which flat or thin plate-shaped members are stacked and assembled, assembly is also facilitated.

### [Configuration of Vibration Presentation Device]

FIG. 8 is a diagram illustrating an example of vibration presentation device 100 including vibration actuator 10A. Note that, in FIG. 8, a planar trackpad body that is operated by touch by an operator's finger is shown transparently for convenience.

Vibration presentation device 100 is, for example, a trackpad serving as a pointing device used in place of a mouse in a laptop computer or the like. The trackpad as vibration presentation device 100 is disposed in a rectangular opening provided in a housing of a laptop computer or the like. The trackpad includes: pad body 110 that has a plate-shape and is traced by a finger as a touch operation; vibration actuator 10A disposed on a back side of pad body 110; frame portion 130 surrounding vibration actuator 10A; and control section 140 that controls vibration actuator 10A.

In the trackpad, when a touch operation such as tracing or tapping pad body 110 with a finger is performed, vibration actuator 10A imparts vibration serving as a haptic sensation. Specifically, control section 140 applies a voltage (supplies current) to coils 52 to 54 of vibration actuator 10A in response to a touch operation by a user on pad body 110, which is an operation surface, displaces movable portion 40 downward, initiates vibration, and presents a haptic sensation to the user.

Pad body 110 is fixed, for example, at the back side of its central portion to movable portion 40 of vibration actuator 10A using double-sided tape or the like. Vibration actuator 10A is fixed to a bottom surface portion of frame portion 130 via base frame 20. Furthermore, an outer peripheral portion of pad body 110 is movably attached to frame portion 130 via a buffer member.

In the above description, movable portion 40 is attached to pad body 110, and base frame 20 is attached to frame portion 130; however, base frame 20 (or cover frame 70) may be attached to pad body 110 and movable portion 40 may be attached to frame portion 130.

In the fixing method for vibration actuator 10A described above, pad body 110 is directly actuated (direct actuation method); however, one of base frame 20 or movable portion 40 may be fixed to pad body 110 while the other need not be fixed to frame portion 130 or the like (suspension method). In this fixed state, by vibrating base frame 20 or movable portion 40 relative to the other, vibration is indirectly propagated to pad body 110.

Furthermore, although vibration presentation device 100 including vibration actuator 10A has been described here as an example, vibration presentation device 100 may also be configured to include any of vibration actuators 10B to 10D, which will be described later.

### <Variation 1>

FIG. 9 is an external perspective view of vibration actuator 10B, which is a variation of vibration actuator 10A.

In vibration actuator 10A, when the X direction is taken as the horizontal direction and the Y direction as the vertical direction, the ratio of the lengths in the horizontal and vertical directions is approximately 50:50, that is, vibration actuator 10A is substantially square in plan view; however, the ratio of the lengths in the horizontal and vertical directions may be changed.

For example, vibration actuator 10B illustrated in FIG. 9 has a configuration in which the ratio of the lengths in the horizontal and vertical directions differs from that of vibration actuator 10A, with the lengths of weight portion 41, magnets 42 to 44, and core magnetic poles (reference numerals omitted) being increased in the Y direction. Since vibration actuator 10B has the same configuration as vibration actuator 10A except for the difference described above, the same reference numerals are assigned to the same configurations and redundant descriptions are omitted.

As in vibration actuator 10B, the ratio of the lengths in the horizontal and vertical directions is changed to modify the lengths of weight portion 41, magnets 42 to 44, and core magnetic poles (reference numerals omitted). This allows the weight of weight portion 41 and the magnetic circuit formed by magnets 42 to 44, the core magnetic poles (reference numerals omitted), and coils 52 to 54 to be appropriately adjusted.

### <Variation 2>

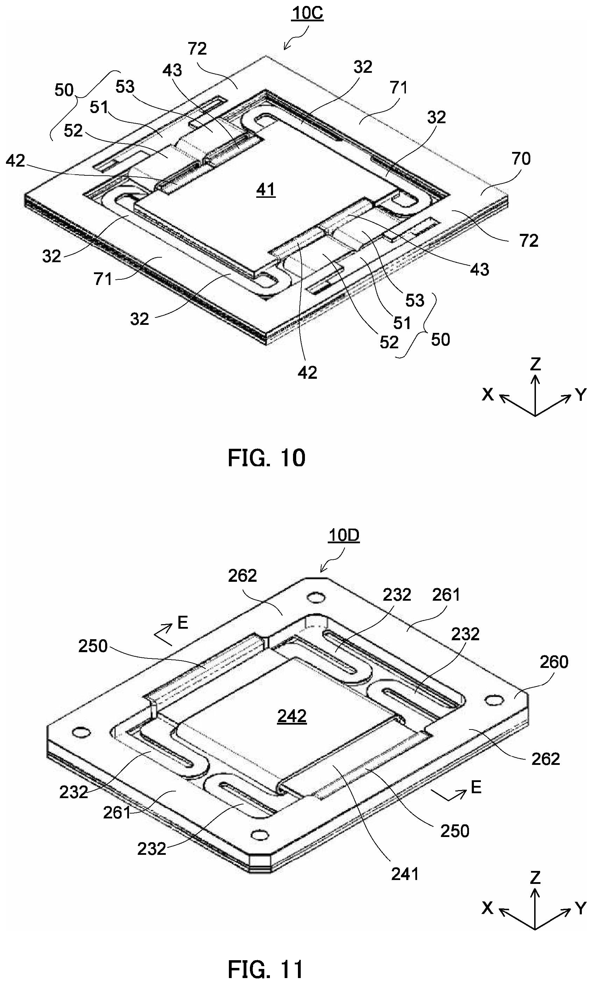

FIG. 10 is an external perspective view of vibration actuator 10C, which is a variation of vibration actuator 10A.

In vibration actuator 10A, both opposing pairs of movable portion 40 and core portion 50 each include three magnets 42 to 44 and three core magnetic poles 51a to 51c and coils 52 to 54; however, these numbers may be changed.

For example, vibration actuator 10C illustrated in FIG. 10 has a configuration in which the both opposing pairs of movable portion 40 and core portion 50 each includes two magnets 42 and 43 and two core magnetic poles (reference numerals omitted) and coils 52 and 53. Since vibration actuator 10C also includes the same configuration as vibration actuator 10A except for the difference described above, the same reference numerals are assigned to the same configurations and redundant descriptions are omitted.

As in vibration actuator 10C, the numbers of magnets, core magnetic poles, and coils are changed. This allows the magnetic circuit formed by the magnets, core magnetic poles, and coils to be appropriately adjusted.

### <Variation 3>

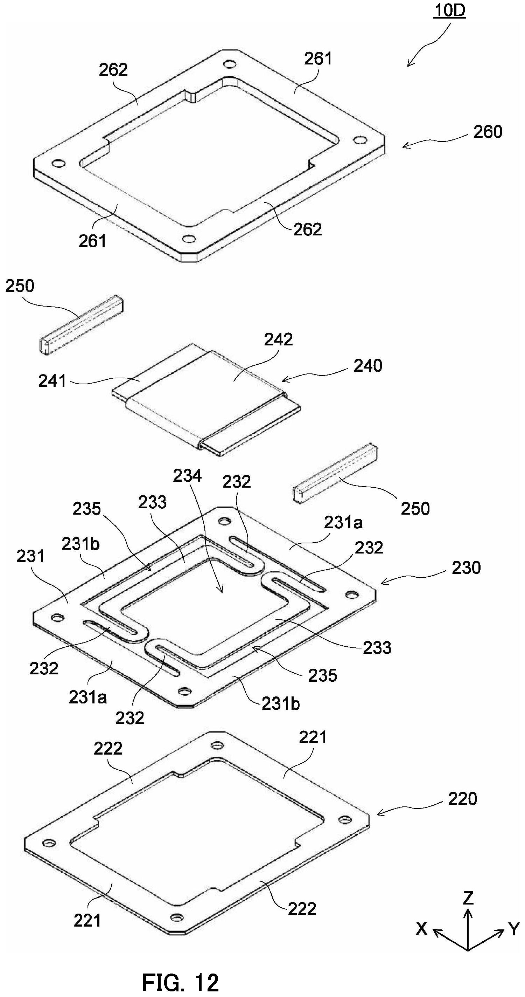

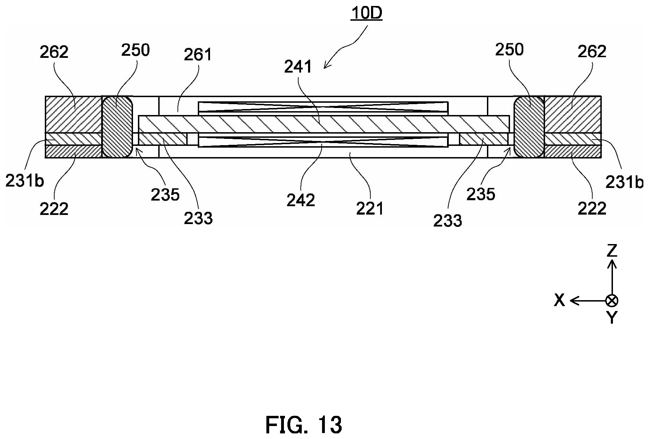

FIG. 11 is an external perspective view of vibration actuator 10D, which is a variation of vibration actuator 10A. FIG. 12 is an exploded perspective view of vibration actuator 10D. FIG. 13 is a cross-sectional view of vibration actuator 10D taken along line E-E. Note that in FIG. 13, vibration actuator 10D is shown enlarged in the thickness direction for illustrative purposes.

In the present variation, vibration actuator 10D includes base frame 220, elastic portion 230, movable portion 240, magnet 250, and cover frame 260 (see, in particular, FIG. 12).

Base frame 220, elastic portion 230, movable portion 240, magnets 250, and cover frame 260 are each formed in a flat or thin plate shape, and thin vibration actuator 10D is configured by stacking these members.

Base frame 220 (lower frame body in the present invention) is a flat or thin plate-shaped frame body, and the inside of the frame is open. As an example, base frame 220 is a rectangular frame body in plan view, and is constituted by first side portions 221 facing each other in the Y direction and second side portions 222 facing each other in the X direction, which is different from the direction of first side portions 221. Base frame 220 interposes elastic portion 230 between itself and cover frame 260, and holds movable portion 240 in a vibratable manner via elastic portion 230.

Elastic portion 230 is a flat or thin plate-shaped elastic member and includes frame portion 231 (end portion in the present invention), arms 232, and holding portions 233. Elastic portion 230 is also a rectangular frame body in plan view, for example, and frame portion 231 is constituted by first side portions 231a facing each other in the Y direction and second side portions 231b facing each other in the X direction, which is different from the direction of first side portions 231a.

Frame portion 231 is disposed at a position overlapping with base frame 220 and cover frame 260 in plan view. Specifically, first side portions 231a of frame portion 231 are disposed at positions overlapping with first side portions 221 of base frame 220 and first side portions 261 of cover frame 260 described later. Furthermore, second side portions 231b of frame portion 231 are disposed at positions overlapping with second side portions 222 of base frame 220 and second side portions 262 of cover frame 260 described later. With this arrangement, frame portion 231 is interposed between base frame 220 and cover frame 260 along its entire periphery.

Arms 232 are four arms extending from the four corners of frame portion 231 to holding portions 233 disposed inside the frame of frame portion 231, and are portions that elastically deform when movable portion 240 held by holding portions 233 vibrates.

As an example, arms 232 each have a shape in which arm 232 extends inward in the X direction from the corner of frame portion 231, then meanders outward in the X direction, and connects to holding portion 233. By forming arms 232 in meandering shapes in this manner, the lengths of elastically deformable arms 232 can be set to desired lengths even when the overall size and length of elastic portion 230 are limited, and the vibration of movable portion 240 can be set to a desired resonance frequency.

In the present variation, elastic portion 230 includes two holding portions 233 in order to hold movable portion 240 including coil 242 (and to secure a space for disposing coil 242). On the positive X-direction side, two arms 232 connect one of second side portions 231b and one of holding portions 233 together, and on the negative X-direction side, two arms 232 connect the other of second side portions 231b and the other of holding portions 233 together. This secures first space 234 for disposing coil 242 between two holding portions 233.

Two holding portions 233 are each disposed inside the frame of frame portion 231 via two arms 232. Both ends of core 241 of movable portion 240 (both ends extending beyond coil 242) are then fixed to the respective holding portions 233 via fixing members such as an adhesive, a fastening member, or a pressure-sensitive adhesive material, whereby holding portions 233 hold movable portion 240. At this time, since first space 234 for disposing coil 242 between two holding portions 233 is secured as described above, coil 242 is disposed within first space 234.

Furthermore, second space 235 is formed between holding portion 233 and second side portion 231b facing holding portion 233, and as illustrated in FIG. 13, magnet 250 is disposed in second space 235.

Movable portion 240 includes core 241 and coil 242. Core 241 is a member formed of a flat or thin plate-shaped magnetic body. Core 241 also functions as a weight that promotes vibration due to its own weight.

Coil 242 is wound around core 241 such that both ends of core 241 are exposed. Both ends of core 241 exposed from coil 242 are fixed to two holding portions 233, respectively, as described above, and are disposed so as to face magnet 250 with gaps therebetween.

Since movable portion 240 is disposed inside the frames of base frame 220 and cover frame 260, no other member is disposed above or below movable portion 240 (in the vibration direction). Therefore, the thickness of movable portion 240 can be maximally ensured within the thickness range of vibration actuator 10D. In this case, the movable range of movable portion 240 (the thickness of movable portion 240 plus the displacement amount in the vibration direction) is set to fall within the thickness range of vibration actuator 10D. This allows the thickness of coil 242 to be maximally ensured. This makes it possible to apply a stronger magnetic force to magnet 250 described later. Furthermore, the weight of core 241 can also be increased.

Magnets 250 are provided so as to correspond to both ends of movable portion 240 (core 241 and coil 242). Magnets 250 are held inside (on the inner frame side of) base frame 220, elastic portion 230, and cover frame 260, and are disposed so as to face both ends of movable portion 240 (core 241 and coil 242) with gaps therebetween. As an example, recesses are provided on the inner sides of base frame 220 and cover frame 260, and magnets 250 are fixed in the recesses.

Furthermore, in the present variation, as illustrated in FIG. 13, the thicknesses of magnets 250 can be maximally ensured within the thickness range of vibration actuator 10D, that is, within the thickness range of the stacked base frame 220, elastic portion 230, and cover frame 260. This makes it possible to increase the magnetic force of magnets 250.

Magnets 250 are magnetized in the vibration direction (Z direction) in the same manner as magnets 42 to 44 of vibration actuator 10A in the above embodiment. Therefore, the operation (vibration) of vibration actuator 10D is basically the same as that of vibration actuator 10A, except for the difference as to whether the movable side is the magnet side or the core and coil side (see FIG. 7 and the description), and a description of the operation is therefore omitted here.

Cover frame 260 (upper frame body in the present invention) is a flat or thin plate-shaped frame body having an opening inside the frame. As an example, cover frame 260 is a rectangular frame body in plan view, and is constituted by first side portions 261 facing each other in the Y direction and second side portions 262 facing each other in the X direction, which is different from the direction of first side portions 261. Cover frame 260 interposes elastic portion 230 between itself and base frame 220.

Vibration actuator 10D is also configured by stacking base frame 220, elastic portion 230, movable portion 240, magnet 250, and cover frame 260, each of which is a flat or thin plate-shaped member. In vibration actuator 10D, the stacked members are fixed to each other using screws or the like as fastening members. Note that an adhesive, welding, or the like may be used as the fastening members.

In vibration actuator 10D, arms 232 and holding portions 233 of elastic portion 230, movable portion 240, and magnets 250 are disposed inside the frames of base frame 220 and cover frame 260. Furthermore, both ends of movable portion 240 (core 241 and coil 242) and magnets 250 are disposed so as to face each other in the X direction with gaps therebetween.

Counting from the back side toward the front side, the first layer is base frame 220, the second layer is elastic portion 230, and the third layer is cover frame 260. Movable portion 240 and magnets 250 are disposed within the thickness range of layers 1 to 3, that is, within the thickness range of the stacked base frame 220, elastic portion 230, and cover frame 260.

In the present variation, all of layers 1 to 3 are frame bodies, and elastic portion 230, which is a frame body, is interposed between base frame 220 and cover frame 260, which are also frame bodies. This ensures rigidity even when vibration actuator 10D is reduced in thickness.

### [Summary]

As described above, in vibration actuator 10D as well, elastic portion 230, which is a frame body, is interposed between base frame 220 and cover frame 260, which are also frame bodies. This ensures the overall rigidity of vibration actuator 10D even when vibration actuator 10D is reduced in thickness.

Furthermore, movable portion 240 and magnet 250 are disposed inside the frames of base frame 220 and cover frame 260. Since no other member is disposed in the vibration direction of movable portion 240 or in the thickness direction of magnet 250, the thicknesses of movable portion 240 and magnet 250 can be maximally ensured within the thickness range of vibration actuator 10D even when vibration actuator 10D is reduced in thickness. This makes it possible to improve the attractive force by which magnet 250 attracts movable portion 240 (core 241 and coil 242).

Furthermore, when assembling (stacking) vibration actuator 10D, assembly accuracy can be improved by using base frame 220 at the lowermost position or cover frame 260 at the uppermost position as a reference.

Furthermore, since vibration actuator 10D has a structure in which flat or thin plate-shaped members are stacked and assembled, assembly is also facilitated.

The embodiment of the present invention has been described above. Note that the above description is illustrative of a preferred embodiment of the present invention, and the scope of the present invention is not limited thereto. That is, the descriptions of the configuration of the above device and the shape of each part are merely examples, and it is apparent that various modifications and additions to these examples are possible within the scope of the present invention.

For example, vibration actuators 10A to 10D described above may each be configured to include a box-shaped housing that houses the vibration actuator itself therein.

The disclosure of Japanese Patent Application No. 2023-178484, filed on October 16, 2023, including the specification, drawings and abstract, is incorporated herein by reference in its entirety.

### Industrial Applicability

The vibration actuator and the contact-type input device according to the present invention have an effect of improving assemblability, being reduced in thickness, and being suitably vibrated, and are useful, for example, as a vibration presentation device used in a contact-type input device such as a trackpad and an operation panel.

### Reference Signs List

10A, 10B, 10C, 10D Vibration actuator
20 Base frame
21 First side portion
22 Second side portion
30 Elastic portion
31 End portion
32 Arm
33 Holding portion
40 Movable portion
41 Weight portion
42, 43, 44 Magnet
50 Core portion
51 Core
51a, 51b, 51c Core magnetic pole
52, 53, 54 Coil
60 Spacer
70 Cover frame
71 First side portion
72 Second side portion
80 FPC
100 Vibration presentation device
110 Pad body
130 Frame portion
140 Control section
220 Base frame
221 First side portion
222 Second side portion
230 Elastic portion
231 Frame portion
232 Arm
233 Holding portion
240 Movable portion
241 Core
242 Coil
250 Magnet
260 Cover frame
261 First side portion
262 Second side portion

## Claims

1. A vibration actuator, comprising:
a magnet;
a core that includes a coil;
an upper frame body having a plate shape;
a lower frame body having a plate shape; and
an elastic portion that includes an end portion disposed at a position overlapping with the upper frame body and the lower frame body in plan view, extends from the end portion into an inside of a frame, and vibratably holds either the magnet or the core inside the frame, wherein
the end portion is interposed between the upper frame body and the lower frame body such that the magnet and the core face each other in the frame.

2. The vibration actuator according to claim 1, wherein
the elastic portion holds the magnet, and
the core is interposed between the upper frame body and the lower frame body.

3. The vibration actuator according to claim 2, wherein
the end portion and the core are interposed between the upper frame body and the lower frame body at mutually different positions in plan view.

4. The vibration actuator according to claim 3, wherein
the upper frame body and the lower frame body are each a frame body having a rectangular shape in plan view and including first side portions facing each other and second side portions facing each other in a direction different from a direction in which the first side portions face each other,
the end portion is interposed at each of the first side portions, and
the core is interposed at each of the second side portions.

5. The vibration actuator according to claim 1, wherein
the elastic portion is capable of vibrating either the magnet or the core in a direction perpendicular to a plane along the upper frame body and the lower frame body, and
the magnet is magnetized in a vibration direction.

6. The vibration actuator according to claim 5, further comprising:
a plurality of the magnets; and
a plurality of the cores respectively facing the plurality of magnets, wherein
magnetization directions of the plurality of magnets adjacent to each other are opposite to each other.

7. A contact-type input device in which the vibration actuator according to claim 5 is disposed on a back side of an operation surface, the contact-type input device comprising:
a control section that energizes the coil in response to a touch operation of a user on the operation surface and vibrates the magnet or the core to present a haptic sensation to the user.
